# EUROPEAN PATENT SPECIFICATION

(11) **EP 1 764 552 B1**
(45) Date of publication and mention of the grant of the patent: **15.04.2009**
(21) Application number: 07000232.4
(22) Date of filing: 17.09.2002
(51) Int. Cl.: F21V 19/02, F21V 14/06

(54) **Variable optics spot module**
Einstellbare Optik für Spot Modul
Module de projecteur à dispositifs optiques variables

(30) Priority: 17.09.2001 US 682535; 21.12.2001 US 683395
(43) Date of publication of application: 21.03.2007
(62) Divisional of application: 02766298.0
(73) Proprietor: Lumination, LLC, Valley View, OH 44125-4635 (US)
(72) Inventor: Sommers, Matthew, Sagamore Hills, OH 44067 (US); Petroski, James T., Parma, OH 44134 (US)
(74) Representative: Simcox, Michael Thomas

(56) References cited:
- EP-A- 1 072 884
- US-A- 6 033 087

## Description

### BACKGROUND OF THE INVENTION

### FIELD OF THE INVENTION

The invention relates to the lighting arts. It is especially applicable to the packaging of light emitting diodes (LED's) to form a spot light, flashlight, or other lamp type that produces a collimated or partially collimated beam, and will be described with particular reference thereto. However, the invention will also find application in packaging of LED's, semiconductor lasers, halogen bulbs, and other light emitting elements for spot lighting, flood lighting, and other optical applications.

### DISCUSSION OF THE ART

Spot light lamps emit a collimated or partially collimated beam of light (e.g., a conical beam), and are employed in room lighting, hand-held flash lights, theater spot lighting, and other applications. Examples of such lamps include the MR-series halogen spot lights which incorporate an essentially nondirectional halogen light bulb arranged within a directional reflector, such as a parabolic reflector. The MR-series halogen spot lights are commercially available with or without a front lens, and typically include electrical connectors disposed behind the parabolic reflector, i.e. outside of the range of the directed beam. The reflector, optionally in cooperation with a front lens, effectuates collimation of the halogen light bulb output to produce the collimated or conical light beam. The MR-series spot lights are available in a range of sizes, wattages, color temperatures, and beam angles. However, the MR-series spot lights do not include adjustable beams.

The Maglite® flashlight is a prior art device that has an adjustable spot beam. An incandescent light bulb is arranged inside an essentially parabolic reflector. This device effectuates a variable beam angle ranging from a narrow spot beam to a wide, "flood" beam, by including a rotating actuator for moving the reflector axially with respect to the incandescent bulb. This arrangement suffers from significant beam non-uniformity when the light source is strongly defocused. Under conditions of extreme defocusing, the Maglite® flashlight beam exhibits a black spot at the beam's center.

Lamps which utilize one or more LED's as the source of light are becoming more attractive as the light output intensities of commercial LED's steadily increase over time due to design, materials, and manufacturing improvements. Advantageously for spot module applications, commercial LED's typically have a lensing effect produced by the epoxy encapsulant that is usually employed to seal the LED chip from the environment. Hence, these commercial LED's are already somewhat directional, and this directionality can be enhanced using an external lens. Additionally, LED's that emit white light of reasonably high spectral quality are now available. In spite of continuing improvements in LED light output, at present an individual LED is typically insufficiently bright for most lighting applications. Nonetheless, due to the small size of LED's, this intensity limitation can be obviated through the use of a plurality of closely packed LED's that cooperate to produce sufficient light.

Application of LED's to spot lighting applications, and especially to spot lighting applications in which the LED-based lamp is contemplated as a retrofit for replacing an existing lamp that employs another lighting technology (e.g., a retrofit for replacing an MR-series halogen lamp) is complicated by the use of multiple LED's as the light source. The spatially distributed nature of an LED source array greatly reduces the effectiveness of conventional parabolic reflectors which are designed to collimate and direct light emanating from a point source, such as light generated by a halogen or incandescent bulb filament. Furthermore, a front lens of the type optionally included in an MR-series halogen spot lamp is ill-suited for collimating light from a plurality of LED's, because most of the LED's are not positioned on the optical axis of the lens. Thus, the optical systems of existing spot lamps, both with and without variable beam angle, are relatively ineffective when used in conjunction with LED light sources.

EP 1 072 884 discloses an illuminator which has a printed circuit board supporting a ring of light emitting diodes. An angular Fresrial lens and the board are both mounted in a housing having a central through-hole for a camera field of view. The lens mixes light from the light emitting diode in the tangential direction and it also controls in the radial directions so there is uniform illumination over a target plane.

US 6,252,350 discloses a lamp with a printed circuit board disposed in a lamp housing with a surface mounted light emitting diode and a non-surface amounted light remitting diode installed on the printed circuit board. Variations in the optical performance may be achieved by combining the surface mount light emitting diodes with non-surface mount light emitting diodes.

The present invention contemplates an improved light source or lamp that overcomes the above-mentioned limitations and others.

### BRIEF SUMMARY OF THE INVENTION

In accordance with one embodiment of the present invention, there is provided claim 1, a lamp including:
a substrate **(112, 142, 152);**
a first lighting unit **(114A)** comprising:
   a first light emitting diode (LED) **(116A, 146A, 156A)** arranged on the substrate **(112, 142, 152),** and
   a first lens element **(124A)** having a first optical prescription and being arranged to interact with light produced by the first LED **(116A, 146A, 156A)** in order to effectuate a first angular distribution or spatial pattern of the light emitted
   a second lighting unit **(114B)** comprising:
      a second light emitting diode (LED) **(116B; 146B, 156B)** arranged on the substrate **(112, 142, 152)** and
      a second lens element **(124B)** having a second optical prescription and being arranged to interact with light produced by the second LED **(116B, 146B, 156B)**; in order to effectuate a second angular distribution or spatial pattern of the light emitted different from the first angular distribution or spatial pattern of the light emitted **characterized in that** the lamp unit is further comprising
   a control unit **(130)** having at least two selectable operational modes including:
      a first selectable operational mode in which power is applied to the first lighting unit **(114A)**, and
      at second selectable operational mode in which power is applied to the second lighting unit **(114B)**, such that the first and second angular distribution or spatial pattern of the light emitted can be selectively obtained.

Numerous advantages and benefits of the present invention will become apparent to those of ordinary skill in the art upon reading and understanding the following detailed description.

### BRIEF DESCRIPTION OF THE DRAWINGS

The invention may take form in various components and arrangements of components, and in various steps and arrangements of steps. The drawings are only for purposes of illustrating a preferred embodiment and are not to be construed as limiting the invention.
FIGURE **1** shows an isometric view of a zoomable spot lamp.
FIGURE **2** shows a schematic cross-sectional view of a zoomable spot lamp, the lamp being shown as adjusted to produce a wide-angle flood beam.
FIGURE **3** shows a schematic cross-sectional view of the lamp of FIGURE **2****,** adjusted to produce a narrow-angle spot beam.
FIGURE **4** shows a front view of the lamp of FIGURE **2****,** looking directly into the beam, with dotted lines indicating the hidden sleeves of the zoom apparatus and the interlocking mechanism.
FIGURE **5** shows a schematic cross-sectional view of the lamp of FIGURE **2** in a first mounting configuration.
FIGURE **6** shows a schematic cross-sectional view of the lamp of FIGURE **2** in a second mounting configuration.
FIGURE **7** shows a schematic cross-sectional view of a zoomable spot lamp, the lamp being shown as adjusted to produce a wide-angle flood beam.
FIGURE **8A** shows a front view of the lamp of FIGURE **7**, looking directly into the beam, with the zoom apparatus rotated at a reference position, herein designated as 0°, between the first and second sleeves.
FIGURE **8B** shows a front view of the lamp of FIGURE **7**, looking directly into the beam, with the second sleeve rotated 120° compared with its reference orientation of FIGURE **8A****.**
FIGURE **8C** shows a front view of the lamp of FIGURE **7**, looking directly into the beam, with the second sleeve rotated 240° compared with its reference orientation of FIGURE **8A****.**
FIGURE **8D** shows a front view of the lamp of FIGURE **7**, looking directly into the beam, with the second sleeve rotated slightly more than 240° compared with its reference orientation of FIGURE **8A**.
FIGURE **9** shows a perspective view of another lamp or light source;
FIGURE **10** shows a cross-sectional view of the lamp or light source of FIGURE **9** taken perpendicular to the substrate along the Line L-L shown in FIGURE **9****;**
FIGURE **11** shows an schematic representation of the electrical configuration of the lamp or light source of FIGURES **9** and **10**;
FIGURE **12** shows a perspective view of a lamp or light source; and
FIGURE **13** shows a perspective view of a lamp or light source.

### DETAILED DESCRIPTION OF THE INVENTION

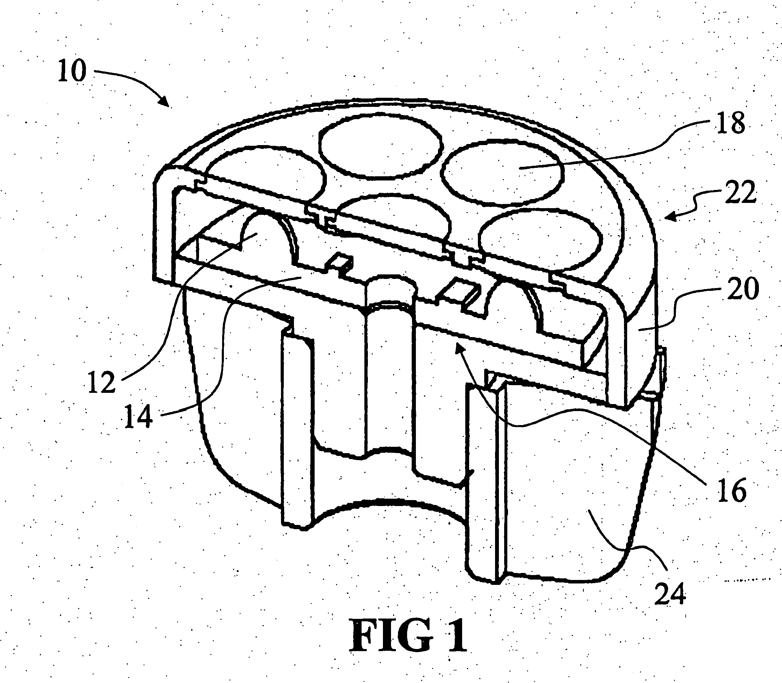

With reference to FIGURE **1**, a lamp or light source **10** includes a plurality of light emitting diodes (LED's) **12** arranged on a base or substrate **14**, the combination of which forms an LED module **16.** A plurality of lenses **18** are arranged in conjunction with the LED's **12**, such that each LED **12** lies on the optical axis of one of the lenses **18.** The lenses **18** effectuate a collimation of the light emitted by the LED's **12,** so that the lamp output is a collimated or conical beam having a desired angle of divergence. Preferably, the LED's **12** are positioned closely to the lenses **18** to maximize the light captured. For this reason, the lenses **18** should be fast lenses, i.e., should have a low f number. These preferred lens optical properties are not readily obtainable using conventional lenses. Accordingly, fresnel lenses are advantageously used for the lenses **18** to provide very low f number behavior in a reasonably sized lens.

In FIGURE **1**, there is a one-to-one correspondence between lenses **18** and LED's **12**. That is, each LED **12** is associated with a single lens **18.** This in turn allows each LED **12** to lie on the optical axis of its corresponding lens **18,** which maximizes the optical efficiency of the combination. In other words, the spatial pattern of the lenses **18** corresponds with the spatial pattern of the LED's **12.**

The lenses **18** are arranged on a zoom apparatus **20** which together with the lenses form an adaptive optical system **22**. The optical system **22** is relatively adjustable with respect the LED module **16** to enable a selectable distance separation along the optical axis between the lenses **18** and the LED's **12.**

Because the lamp **10** is intended for lighting applications, the LED's **12** preferably emit light at high intensities. This entails electrically driving the LED's **12** at relatively high currents, e.g., as high as a few hundred milliamperes per LED **12.** Because LED light emission is very temperature-sensitive, the heat dissipated in the LED's **12** as a consequence of the high driving currents is advantageously removed by a heat sink **24** which is thermally connected with the substrate **14**.

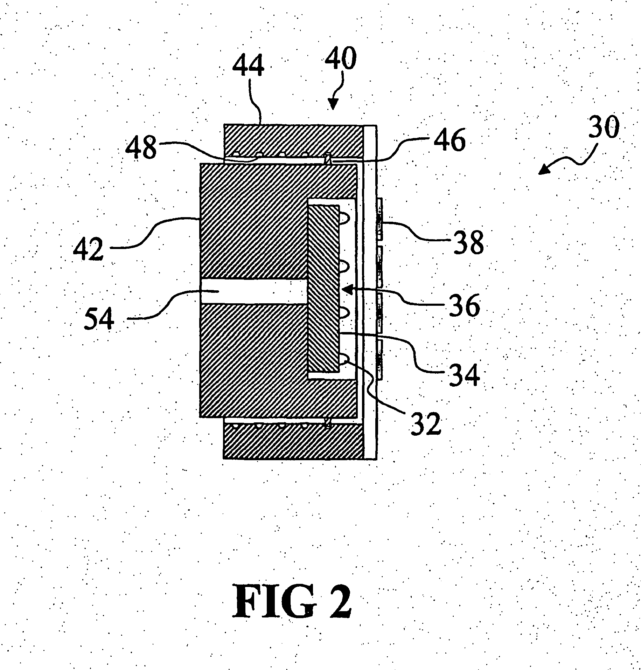

With reference now to FIGURES **2** through **4****,** a lamp **30** in which the zoom apparatus operates on a mechanical sliding principle is described. LED's **32** are arranged on a substrate **34** forming an LED module **36.** A plurality of lenses **38,** which are preferably Fresnel lenses, are arranged in correspondence with the LED's **32**, with each LED **32** lying on the optical axis of an associated lens **38**. A sliding zoom apparatus **40** includes two slidably interconnecting elements or sleeves **42, 44.** The LED module **36** is arranged on or in the first sleeve **42** in a fixed manner. The lenses **38** are arranged on or in the second sleeve **44,** also in a fixed manner. It will be appreciated that zoom apparatus **40** of the lamp **30** effectuates beam width adjustment through the relative motion of the sleeves **42, 44.**

The configuration of the zoom apparatus **40** shown in FIGURE **2** corresponds to a minimum relative separation between the LED's **32** and the lenses **38.** This configuration produces a wide beam, i.e., a conical beam with a wide angle of divergence, sometimes called a flood light.

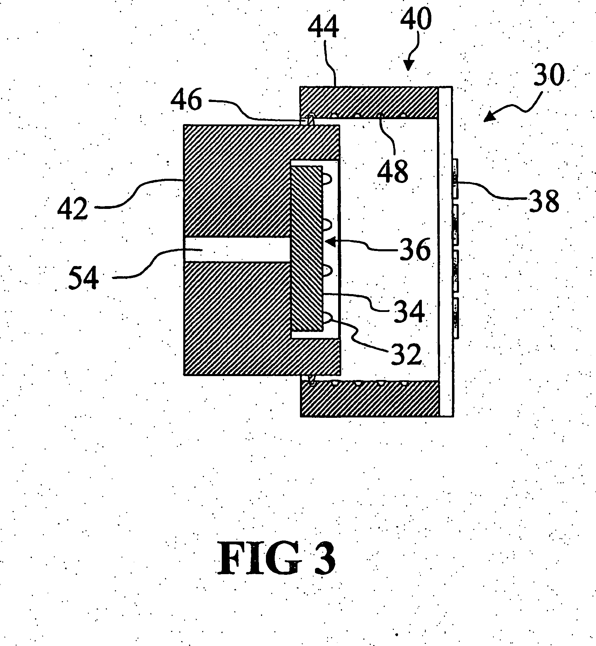

The configuration of the zoom apparatus **40** shown in FIGURE **3** corresponds to a maximum relative separation between the LED's **32** and the lenses **38**. This configuration produces a narrow beam, i.e., a conical beam with a small angle of divergence, sometimes called a spot light.

A sliding zoom apparatus can optionally effectuate continuous zoom adjustment (not shown). For continuous zoom adjustment, the sleeves should be of sufficiently close relative tolerances so that the frictional force between the two sleeves **42, 44** inhibits unintended sliding slippage therebetween.

Alternatively, as shown in FIGURES **2** and **3**, the zoom apparatus **40** is an indexed zoom apparatus. A projection or stop **46,** which can be a single projection, a plurality of projections, or an annular projection, extends from the first sleeve **42** and is selectably moved into one of five recesses or stop positions **48,** which can be annular grooves, holes, or the like. The projection(s) **46** and the recesses **48** are mutually adapted to enable relative movement of the sleeves **42, 44** to selectably move the stop **46** to a selected stop position **48.** The projections or stop **46** and the recesses or stop positions **48** cooperate to bias the zoom apparatus into certain pre-selected axial spadngs or stop positions. It will be appreciated that such an index system tends to reduce slippage between the two sleeves **42, 44** versus a similar continuous zoom adjustment which relies upon fictional force to prevent slippage. Of course, the index system of FIGURES **2** and **3** is exemplary only, and many variations thereof are contemplated, such as placing the stop onto the first sleeve and the recesses onto the second sleeve, using other than five stop positions, etc.

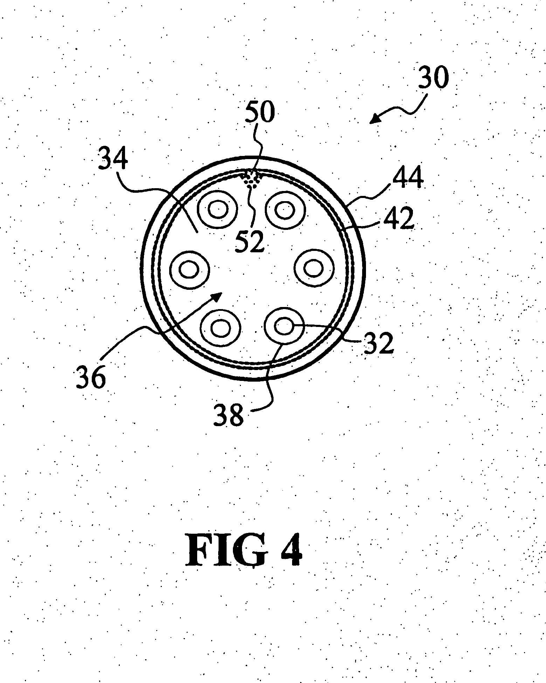

With reference to FIGURE **4****,** in addition to the zoom indexing system exemplarily effectuated by projection(s) **46** and recesses **48,** the lamp **30** also includes an advantageous interlocking mechanism including a linear projection **50** aligned along the sliding direction of the sliding zoom apparatus **40** and extending inwardly from the second sleeve **44** toward the first sleeve **42,** and a corresponding linear depression **52** that receives the linear projection **50**. This interlocking mechanism prevents relative rotation between the first and second sleeves **42, 44** so that the LED's **32** are maintained centered on the optical axes of the lenses **38.**

With reference to FIGURES **2** and **3****,** the lamp **30** also includes one or more electrical conduits **54** through which wires or other electrical conductors (not shown) connect the LED's to an associated power supply (not shown). Although an exemplary single conduit **54** is shown, numerous variations are contemplated, such as separate conduits for each LED **32.**

In addition, electrical components such as a printed circuit board that electrically connects the LED's **32** and has optional driving electronics operatively arranged thereupon, metallized connections, an associated battery or other electrical power supply, etc. are also contemplated (components not shown). It will be recognized that such electrical components are well known to those skilled in the art.

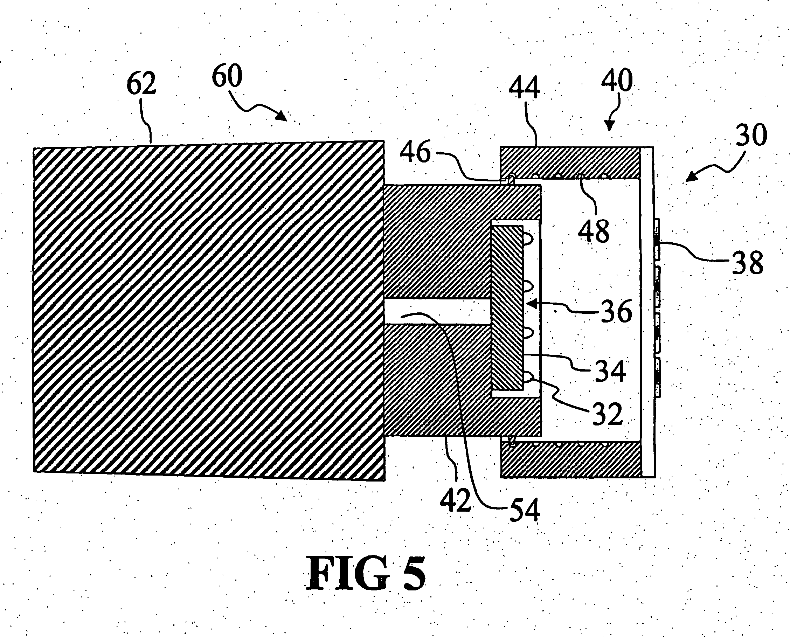

With reference to FIGURE **5****,** a mounting configuration **60** for the lamp **30** of FIGURES **2** through **4** is described. In the mounting configuration **60,** the inner sleeve **42** remains fixed relative to a mounting element **62,** while the sliding movement of the outer sleeve **44** effectuates the zoom adjustment. The mounting element **62** could, for example, be the approximately cylindrical body of a hand flashlight that contains associated batteries to power the lamp **30**, in which case movement of the outer sleeve **44** is effectuated manually by the user. Alternatively, for a theater stage spotlight mounting configuration, the movement of sleeve **44** could be mechanized. It will be appreciated that the mounting configuration **60** is rather simple to construct because the adjustable outer sleeve **44** is accessible.

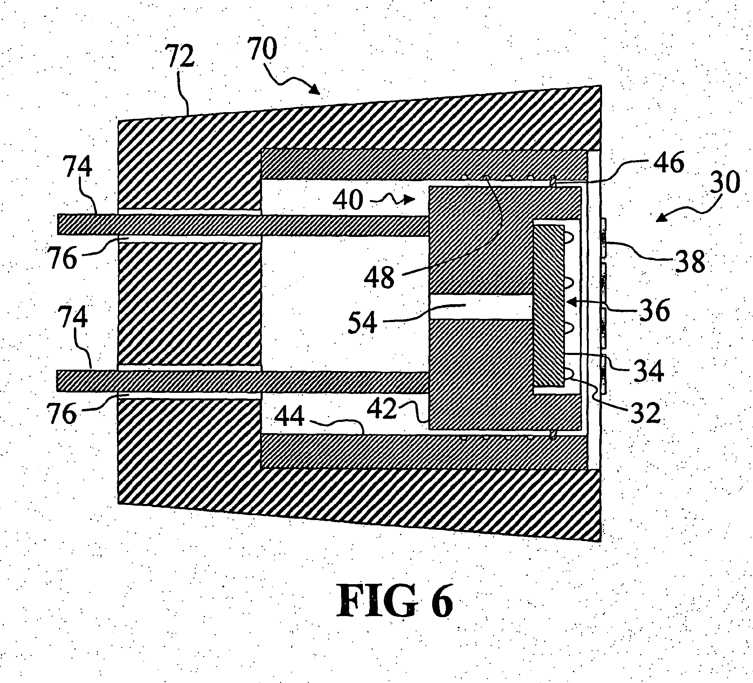

With reference to FIGURE **6****,** another mounting configuration **70** for the lamp **30** of FIGURES **2** through **4** is described. In the mounting configuration **70,** the outer sleeve **44** remains fixed relative to a mounting element **72,** while movement of the inner sleeve **42** effectuates the zoom adjustment. In this case, the inner sleeve **42** is relatively inaccessible from outside the mounting configuration **70,** and so in FIGURE **6** one or more posts **74** are rigidly affixed to the inner sleeve **42** and pass through passthroughs **76** in the mounting element **72** to provide handles or shafts by which the inner sleeve **42** is slidably adjusted to effectuate the zoom. The mounting configuration **70** is therefore more complex versus the mounting configuration **60** of FIGURE **5**. However, the mounting configuration **70** has the advantage of fully containing the lamp **30** within the mounting element **72** so that a lighting device that employs the configuration **70** has definite and fixed outside dimensions. The one or more posts **74** are also easily adapted to connect with a motor (not shown) to effectuate a mechanized zoom adjustment.

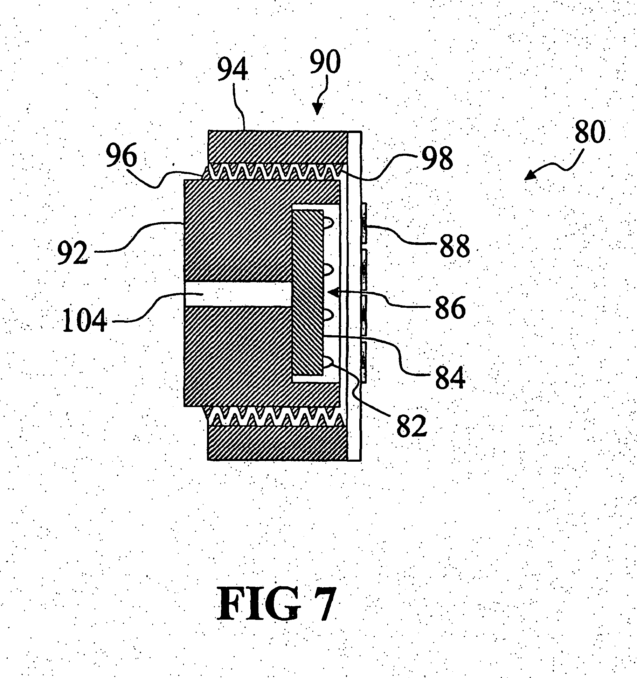

With reference to FIGURE **7**, a lamp **80** in which the zoom apparatus operates on a mechanical rotation principle is described. LED's **82** are arranged on a substrate **84** forming an LED module **86.** A plurality of lenses **88**, which are preferably Fresnel lenses, are arranged in the same pattern as the LED's **82.** The rotating zoom apparatus **90** includes two threadedly interconnecting elements or sleeves **92, 94,** The LED module **86** is arranged on or in the first sleeve **92** in a fixed manner. The lenses **88** are arranged on or in the second sleeve **94,** also in a fixed manner. Thus, by relatively screwing the first and second sleeves **92, 94** into or out of each other using the cooperating threads 96, 98 disposed on the outside of the first sleeve **92** and the inside of the second sleeve **94,** respectively, the relative axial separation of the LED's **82** and the lenses **88** is adjusted. The first sleeve **92** preferably includes one or more electrical conduits **104** which are analogous to the conduit or conduits **54** of FIGURE **2**.

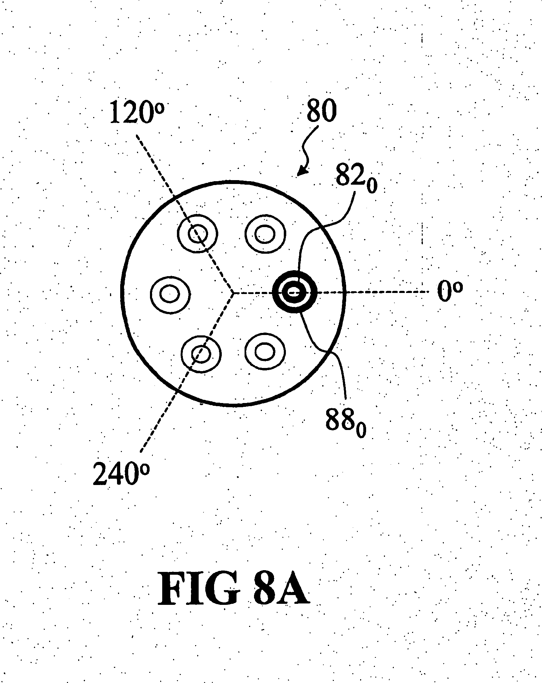

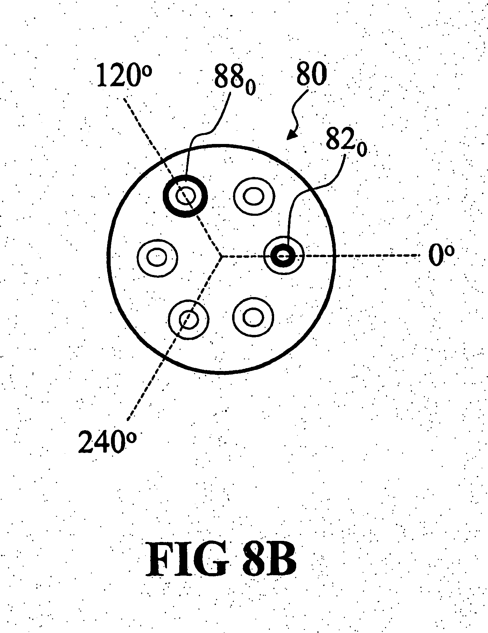

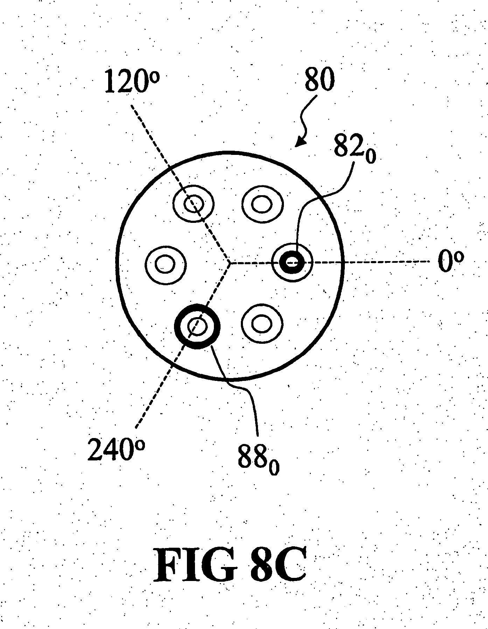

Although the LED's **82** and the lenses **88** are arranged in the same spatial pattern, it will be recognized that the rotating motion in general results in a misalignment of the LED's **82** off the optical axes of the lenses **88**. However, for certain relative rotational orientations of the sleeves **92, 94,** the two patterns align, as shown in FIGURE **8A****.** The relative rotational orientation shown in FIGURE **8A** is herein designated as 0° and serves as a reference orientation. Furthermore, a specific LED **82₀.** and a specific lens **88₀,** are shown in bold in FIGURE **8A** and will be tracked during zoom adjustment using FIGURES **8B** and **8C** in the discussion which follows.

With reference to FIGURE **8B****,** the reference orientation has been changed by rotating the second sleeve **94** counter-dockwise by 120°. Two changes result from the 120° rotation. First, the axial separation of the LED's **82** and the lenses **88** changes by an amount related to the spacing of the threads **96, 98** due to the screwing action. Second, the lens **88₀** is no longer axially aligned with the LED **82₀,** but rather now axially aligns with another LED as seen in FIGURE **8B****.**

With reference to FIGURE **8C****,** the second sleeve **94** has been rotated counter-clockwise by another 120° (240° total rotation versus FIGURE **8A****).** The axial separation of the LED's **82** and the lenses **88** is again changed by an amount related to the spacing of the threads **96, 98,** and the lens **88₀** axially aligns with yet another LED as seen in FIGURE **8C****.** Although not illustrated as a separate figure, it will be recognized that a third counter-clockwise rotation of 120° would bring the total rotation versus FIGURE **8A** up to 360°, i.e. one complete rotation, and would re-produce the pattern alignment shown in FIGURE **8A****.** but with a change in axial spacing between the LED's **82** and the lenses **88** corresponding to the spacing of the threads **96, 98.**

The threads **96, 98** may have thread joints, indented stops or another mechanism (not shown) to bias the zoom apparatus **90** into indexed positions such as those shown in FIGURES **8A****,** **8B****,** and **8C** wherein the lens **88** pattern aligns with the LED **82** pattern. It will be recognized that if the lens **88** pattern and the LED **82** pattern each have an n-fold rotational symmetry, then separation of the rotational stop positions by integer multiples of 360°/n enables stop positions for which each LED **82** is axially aligned with one of the plurality of lenses **88.** In FIGURES **8A****,** **8B** and **8C****,** the patterns have six-fold rotational symmetry (n=6), and the stop positions are separated by 2×(360°/n)= 120 ° rotations.

The rotation of the zoom apparatus **90** can also be continuous with no index biasing. In this case the frictional interaction between the threads **96, 98** should be sufficient to counteract slippage of the zoom apparatus **90**.

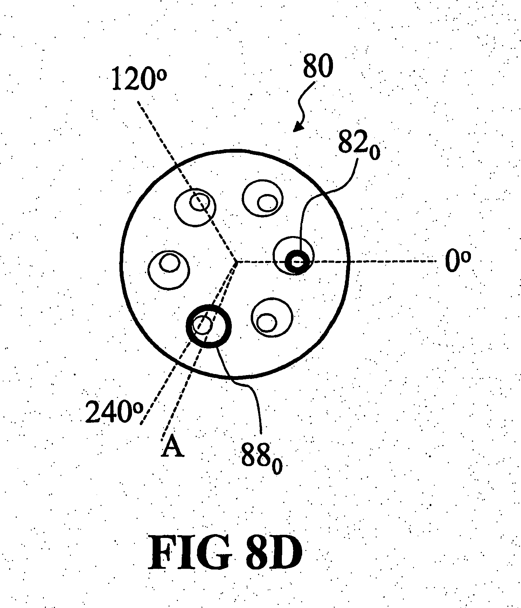

FIGURE **8D** shows a relative rotational orientation of the LED **82** pattern and the lenses **88** pattern wherein the LED's **82** are not axially aligned with the lenses **88,** but rather are relatively positioned slightly off-axis. It will be recognized that a relative pattern orientation such as that shown in FIGURE **8D** can be obtained either with or without index biasing. Such a slightly off-axis relative orientation produces defocusing which can provide further freedom for adjusting the light beam properties. In FIGURE **8D**, the second sleeve **94** has been rotated to an angle A relative to the reference rotational orientation of FIGURE **8A****,** where the angle A is slightly greater than the 240° orientation that would produce pattern alignment.

In FIGURES **1-8D** the LEDs are shown as substantially similar, and the beam spot size or other beam characteristics is changed by relative mechanical movement of a lensing system and an LED assembly. However, the LEDs can be different. Moreover, as described next, beam spot size or other beam characteristics are changed by selectively energizing selected LEDs or sets of LEDs in which the LEDs or sets of LEDs are different and/or have different coupled optics.

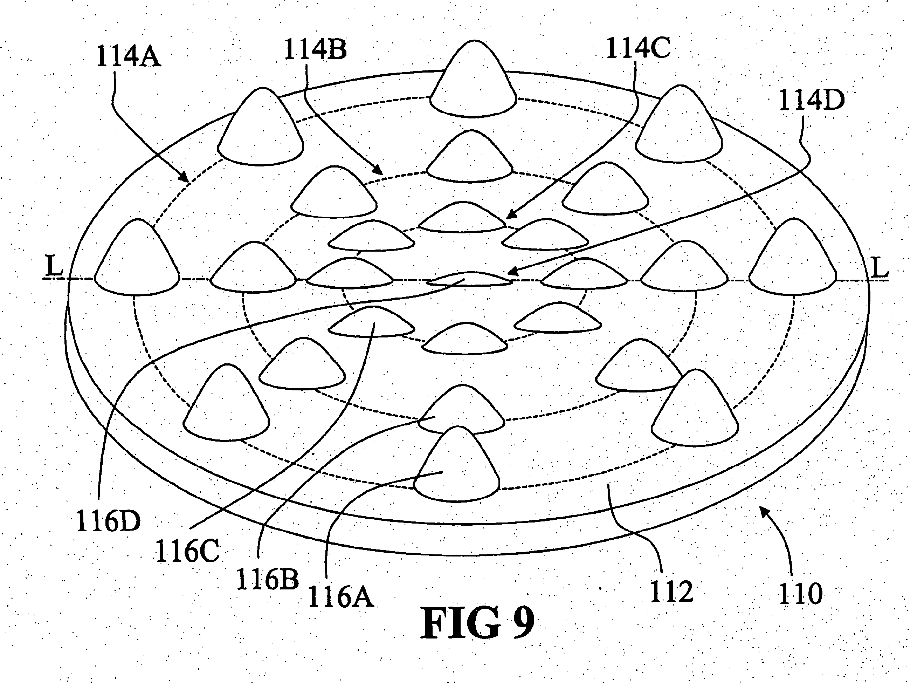

With reference to FIGURE **9**, a lamp or light source **110** includes a substrate **112** which is circular in shape. Arranged on the substrate **112** are a plurality of optical sources or lighting units **114A, 114B, 114C, 114D.** Each of the lighting units or optical sources **114A, 114B, 114C, 114D** include one or more light emitting diode (LED) components. The optical source **114A** comprises eight LED components **116A.** The optical source **114B** comprises eight LED components **116B.** The optical source **114C** comprises eight LED components **116C.** The optical source **114D** comprises only a single LED component **116D.** In FIGURE **9****,** the lighting unit **114D** that includes only a single LED component **116D** is located at the center of the substrate **112.** The lighting units **114C, 114B,** and **114A** are arranged in concentric circular patterns of increasing diameter, respectively, about the lighting unit **114D.**

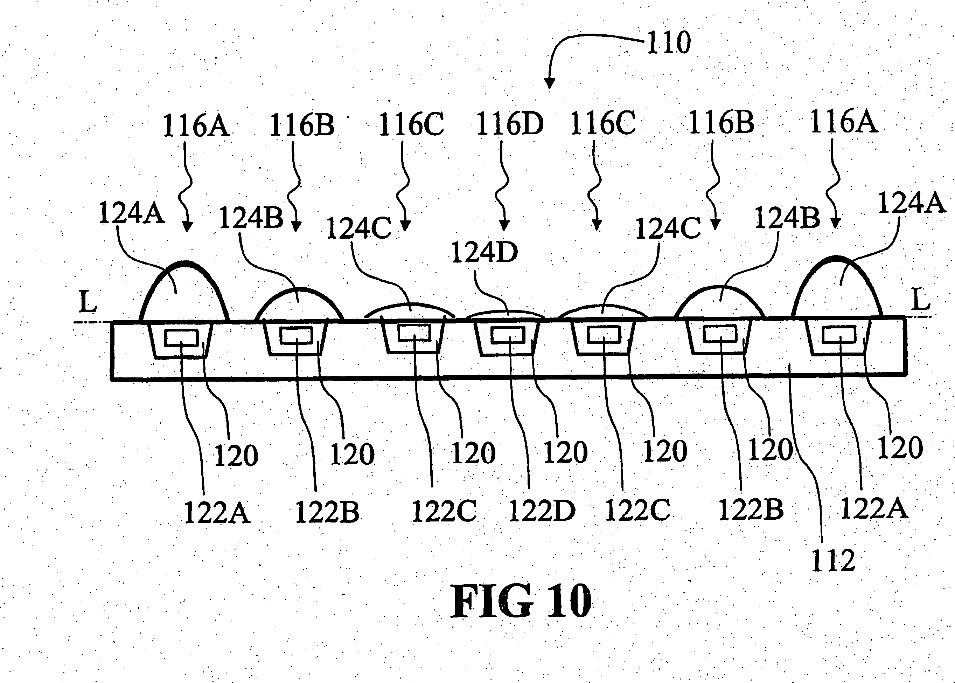

With continuing reference to FIGURE **9** and with further reference now to FIGURE **10****,** the LED components **116A, 116B, 116C, 116D** are described. FIGURE **10** shows a cross-sectional view of the lamp or light source **110** taken perpendicular to the substrate **112** along the Line L-L shown in **FIGURE 9****.** A plurality of wells **120** are formed in the substrate **112** for receiving LED elements **122A, 122B, 122C, 122D** that correspond to the LED components **116A, 116B, 116C, 116D,** respectively. The substrate **110** is manufactured using a thermal-heat sinking material such as a copper plate. Mounting of the LED elements and electrical contacting thereof are steps that are well known to the art and need not be described herein for an enabling disclosure.

It will be appreciated that the LED elements **122A, 122B, 122C, 122D** need not be identical to one another, but can instead include LED elements emitting light at different colors or with different spectral distributions, different optical intensities, and the like. The **LED** elements **122A, 122B, 122C, 122D** can be manufactured from different materials, e.g. LED element **122A** can be a group III-nitride LED element emitting blue light, whereas LED element **122B** can be a group III-phosphide LED element emitting red light. Furthermore, in the case of a plurality of LED elements comprising a lighting unit or optical source, e.g. the optical source **114A,** every LED element of the plurality need not be identical. For simplicity, however, FIGURE **2** shows all the LED elements **122A, 122B, 122C, 122D** as being essentially identical.

The LED components **116A, 116B, 116C, 116D** also include optical elements such as lenses **124A, 124B, 124C, 124D.** In order to effectuate different angular distributions or spatial patterns for the light emitted by the lighting units **114A, 114B, 114C, 114D,** the corresponding optical elements or lenses **124A, 124B, 124C, 124D** each have different optical prescriptions, The lenses **124A, 124B, 124C, 124D** can be discrete elements that are mounted above the wells **120.** Alternatively, the optical elements **124A, 124B, 124C, 124D** can be formed by controlled shaping or molding of an epoxy or resin encapsulant that is used to hermetically seal the LED elements **122A, 122B, 122C, 122D.** In FIGURES **9** and **10**, the different optical prescriptions are effectuated by different radii of the conic of the lenses or epoxy "bumps" **124A, 124B, 124C, 124D.** Of course, other approaches for effectuating a pre-selected optical prescription can also be employed, such as by using different materials having different refractive indexes for each type of optical element **124A, 124B, 124C**, **124D.** It will also be appreciated that the optical elements **124A, 124B, 124C, 124D** can, in addition to effectuating pre-selected optical prescriptions, also alter the light emitted by the optical sources **114A, 114B, 114C, 114D** in other ways. For example, the optical elements or lenses **124A, 124B, 124C, 124D** can be selectively tinted to alter the color or spectral distribution of the light passing therethrough in a pre-selected manner.

FIGURE **10** is exemplary only. Other configurations for the LED components **116A, 116B, 116C, 116D** and for the substrate **112** are also contemplated. For example, the substrate **112** can be a printed circuit board (PC board) with the LED elements **122A, 122B, 122C, 122D** bonded directly thereto. The wells **120** would typically be omitted in this alternate embodiment.

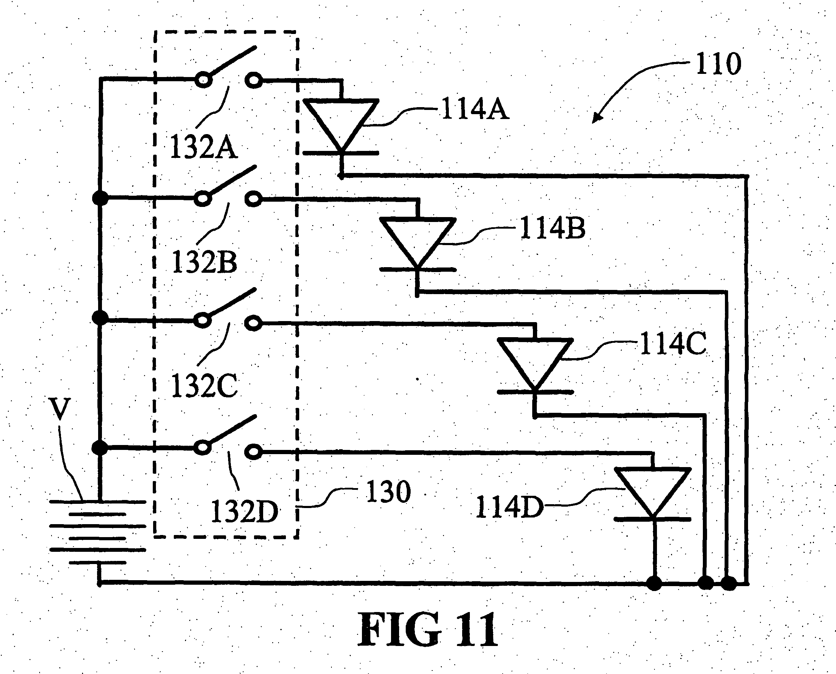

With reference now to FIGURE **11****,** the electrical configuration of FIGURES **9** and **10** is described. An associated voltage source V provides electrical power for the light source or lamp **110** that in FIGURES **9** and **11** includes four optical sources or lighting units **114A, 114B, 114C, 114D.** The lamp **110** further includes a control unit **130** that has four switches **132A, 132B, 132C, 132D** for selectively applying electrical power to the corresponding lighting units **114A, 114B, 114C, 114D.** The switches **132A, 132B, 132C, 132D** can be manual switches, electronically controlled switches, or other switch types. The control unit **130** optionally includes additional elements (not shown) such as a computer interface or components for conditioning the power applied to the lighting units. In the illustrated electrical configuration of FIGURE **11****,** the four lighting units **114A, 114B, 114C, 114D** are independently selectable, and any combination of the lighting units **114A, 114B, 114C, 114D** can be selectively powered at any given time. Each of the lighting units **114A, 114B, 114C, 114D** has a different optical prescription, obtained in FIGURES **9** and **10** by using different conic radii for the lenses **124A, 124B, 124C, 124D.** Thus, by operating only a selected one of the four lighting units **114A, 114B, 114C, 114D** four different angular distributions or spatial patterns of emitted light can be selectively obtained. By operating a selected sub-set of the plurality of optical sources **114A, 114B, 114C, 114D,** complex combinations of the spatial light distributions of the individual optical sources **114A, 114B, 114C, 114D** can be obtained. In a limiting operational case, all four optical sources **114A, 114B, 114C, 114D** can be operated simultaneously using the electrical configuration shown in FIGURE **11**.

The electrical configuration of FIGURE **11** is exemplary only, and a number of variations thereof are contemplated. As noted previously, the LED elements **122A, 1228, 122C, 122D** can be of different types, e.g. GaN LED elements, InGaAlP LED elements, and so forth. In cases where the LED elements comprising the lighting units differ, the control unit **130** optionally includes voltage dividers (not shown) or other power conditioning components that control the power applied to each optical source **114A, 114B, 114C, 114D.** Furthermore, as noted previously a given optical source, e.g. optical source **114A,** can include LED elements of different types. In this case, the optical source **114A** would itself include one or more electrical components (not shown) such as voltage dividers that condition the voltage applied to each LED element within the optical source **114A**. In yet another variant, the control unit **130** includes a rheostat, variable voltage divider, or other electrical component (not shown) that enables variable power application to the lamp **110** as a whole or to one or more of the individual lighting units **114A, 114B, 114C, 114D** that are included in the lamp **110.** Such an arrangement advantageously enables the user to control the optical intensity as well as the spatial distribution of the light output.

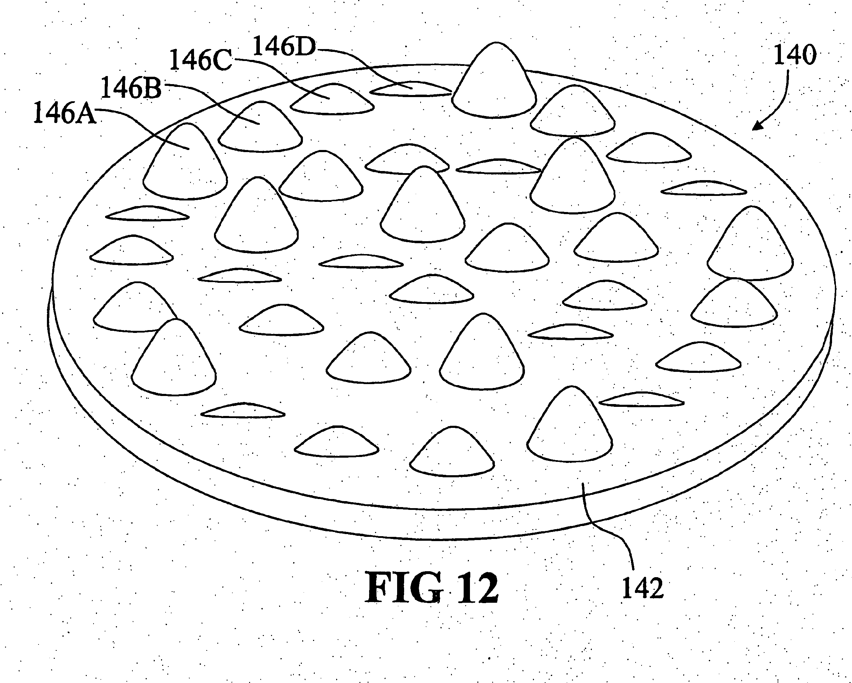

With reference now to FIGURE **12****,** an embodiment **140** of the invention is described. A circular substrate **142** has four lighting units arranged thereon. Each lighting unit includes a plurality of essentially identical LED components. The LED components of each lighting unit differ from the LED components of the other three lighting units. Hence, there are four LED component types **146A, 146B, 146C, 146D** arranged on the substrate **142,** corresponding to the four lighting units. Unlike FIGURE **9**, the embodiment of FIGURE **12** has an equal number of LED components of each type, and the distribution of the LED component types **146A, 146B, 146C, 146D** across the substrate **142** is essentially uniform. Although the spatial distribution of the LED component types is uniform, the lamp **140** nonetheless is capable of producing light having at least four selectable spatial or angular distributions because each of the four LED component types **146A, 146B**, **146C, 146D** has a different optical prescription, as indicated by the different conic radii of the four LED component types **146A, 146B, 146C, 146D.** Thus, the corresponding four lighting units each produce light having a different spatial or angular light distribution.

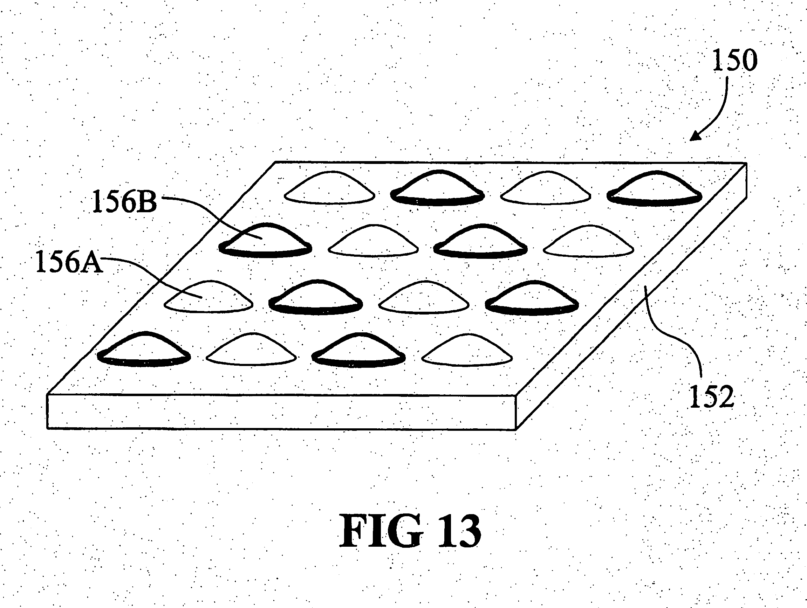

With reference now to FIGURE **13**, a further embodiment **150** of the invention is described. A rectangular substrate **152** has two lighting units corresponding to LED components of types **156A** and **156B,** respectively. The LED component types **156A, 156B** have optical elements with essentially similar conic radii. However, different optical prescriptions are obtained by using materials having different refractive indexes for the optical elements of each component type **156A, 156B.** Hence, the embodiment of FIGURE **13** has a first angular or spatial light distribution obtained when the first optical source comprising the LED components of type **156A** are activated; and a second angular or spatial light distribution obtained when the second optical source comprising the LED components of type **156B** are activated. Optionally, a third angular or spatial fight distribution can be obtained by activating both the first and the second optical sources together, the third angular or spatial distribution operatively combining the first and the second light output distributions.

Those skilled in the art will appreciate that lamps of the type **110, 140, 150** in which beam spot size or other beam characteristics are changed by selectively energizing selected LEDs or sets of LEDs are readily combined with lamps of the type **10, 30, 80** in which the beam characteristics are varied by relative mechanical movement of a lensing system and an LED assembly.

For example, the light source **110** of FIGURE **9** has an eight-fold rotational symmetry that is particularly suitable for use in a rotationally adjustable spot module lamp similar to the lamp **80** of FIGURE **7****.** The light source **110** suitably replaces the LED module **86** of the lamp **80.** The lenses **124** in one contemplated embodiment are located on the second sleeve **94,** that is the lenses **124** replace the lenses **88** of the spot module **80.** In another lamp the lenses **124** are affixed to the light source **110** as shown in FIGURE **9**, and the lenses **88** are separate lenses that cooperate with the lenses **124** to provide the selected optical focusing. The light sources **140, 150** are less suitable for a rotationally adjustable spot module lamp, since these sources **140, 150** would require a 360° rotation. However, any of the light sources **110,140,150** are suitably used in conjunction with a slidably adjustable spot module lamp similar to the lamp **30** of FIGURES **2-4****.**

The invention has been described with reference to the preferred embodiments. Obviously, modifications and alterations will occur to others upon reading and understanding the preceding detailed description. It is intended that the invention be construed as including all such modifications and alterations insofar as they come within the scope of the appended claims or the equivalents thereof.

## Claims

1. A lamp including:
a substrate **(112, 142, 152);**
a first lighting unit **(114A)** comprising:
a first light emitting diode (LED) **(116A, 146A, 156A)** arranged on the substrate **(112, 142, 152),** and
a first lens element **(124A)** having a first optical prescription and being arranged to interact with light produced by the first LED **(116A, 146A, 156A)** in order to effectuate a first angular distribution or spatial pattern of the light emitted
a second lighting unit **(114B)** comprising:
a second light emitting diode (LED) **(116B; 146B, 156B)** arranged on the substrate **(112, 142, 152)** and
a second lens element **(124B)** having a second optical prescription and being arranged to interact with light produced by the second LED **(116B, 146B, 156B)**; in order to effectuate a second angular distribution or spatial pattern of the light emitted different from the first angular distribution or spatial pattern of the light emitted **characterized in that** the lamp unit is further comprising
a control unit **(130)** having at least two selectable operational modes including:
a first selectable operational mode in which power is applied to the first lighting unit **(114A)**, and
at second selectable operational mode in which power is applied to the second lighting unit **(114B)**, such that the first and second angular distribution or spatial pattern of the light emitted can be selectively obtained.

2. The lamp as set forth in claim 1 wherein the control unit **(130)** further has:
a third selectable operational mode in which power is applied to the first lighting unit **(114A)** and to the second lighting unit **(114B).**

3. The lamp as set forth in claim 1 wherein:
light emission from the first LED **(116A, 146A, 156A)** has a first spectral distribution; and
light emission from the second LED **(116B, 146B, 156B)** has a second spectral distribution that is different from the first spectral distribution.

4. The lamp as set forth in claim 1 wherein:
at least one of the first lens element **(124A)** and the second lens element **(124B)** includes a tinted region whereby the spectral distribution of the light emission of the at least one lighting unit **(114A, 114B)** that includes the tinted region is altered in a pre-selected manner by the tinted region.

5. The lamp as set forth in claim 1 further including:
a mechanically movable zoom apparatus **(20, 40, 90)** that includes an optical system **(18, 38, 88)** that interacts with the first and second lighting units **(114A, 114B)** to produce a variable light beam spot size.

## Patentansprüche

1. Lampe mit:
einem Träger (112, 142, 152);
einer ersten Beleuchtungsgruppe (114A), die aufweist:
eine erste lichtemittierende Diode (LED) (116A, 146A, 156A), die auf dem Träger (112, 142, 152) angeordnet ist, und
ein erstes Linsenelement (124A), welches ersten optischen Gesetzen genügt und für die Wechselwirkung mit Licht angeordnet ist, welches von der ersten LED (116A, 146A, 156A) erzeugt wird, um eine erste Winkelverteilung oder räumliche Struktur des emittierten Lichtes zu erzielen,
eine zweite Beleuchtungsgruppe (114B) mit:
einer zweiten lichtemittierenden Diode (LED) (116B, 146B, 156B), die auf dem Träger (112, 142, 152) angeordnet ist, und
einem zweiten Linsenelement (124B), das zweiten optischen Gesetzen genügt und für die Wechselwirkung mit Licht angeordnet ist, welches von der zweiten LED (116B, 146B, 156B) erzeugt wird, um eine zweite Winkelverteilung oder räumliche Struktur des emittierten Lichtes zu erzielen, die sich von der ersten Winkelverteilung oder räumlichen Struktur des emittierten Lichtes unterscheidet,
**dadurch gekennzeichnet, dass**
die Lampeneinheit ferner aufweist:
eine Steuereinheit (130) mit mindestens zwei auswählbaren Betriebsarten mit:
einer ersten auswählbaren Betriebsart, in welcher Strom auf die erste Beleuchtungsgruppe (114A) aufgebracht wird, und
einer zweiten auswählbaren Betriebsart, in welcher Strom auf die zweite Beleuchtungsgruppe (114B) derart aufgebracht wird, dass die erste und zweite Winkelverteilung oder räumliche Struktur des emittierten Lichtes wahlweise erhalten werden kann.

2. Lampe nach Anspruch 1, wobei die Steuereinheit (130) ferner
eine dritte auswählbare Betriebsart hat, in welcher Strom auf die erste Beleuchtungsgruppe (114A) und auf die zweite Beleuchtungsgruppe (114B) aufgebracht wird.

3. Lampe nach Anspruch 1, wobei:
die Lichtemission aus der ersten LED (116A, 146A, 156A) eine erste Spektralverteilung hat; und
die Lichtemission aus der zweiten LED (116B, 146B, 156B) eine zweite Spektralverteilung hat, die sich von der ersten Spektralverteilung unterscheidet.

4. Lampe nach Anspruch 1, wobei
mindestens das erste Linsenelement (124A) und/oder das zweite Linsenelement (124B) einen gefärbten Bereich einschließt, wodurch die spektrale Verteilung der Lichtemission der mindestens einen Beleuchtungsgruppe (114A, 114B), welche den gefärbten Bereich einschließt, durch den gefärbten Bereich in einer vorgewählten Art geändert wird.

5. Lampe nach Anspruch 1, ferner mit
einem mechanisch bewegbaren Zoomgerät (20, 40, 90), welches ein optisches System (18, 38, 88) einschließt, das mit den ersten und zweiten Beleuchtungsgruppen (114A, 114B) wechselwirkt, um einen variablen Lichtstrahlfleck zu erzeugen.

## Revendications

1. Lampe comprenant :
un substrat (112, 142, 152) ;
une première unité d'éclairage (114A) comportant :
une première diode émettrice de lumière (DEL) (116A, 146A, 156A) agencée sur le substrat (112, 142, 152), et
un premier élément à lentille (124A) ayant une première prescription optique et agencé de façon à interagir avec de la lumière produire par la première DEL (116A, 146A, 156A), afin d'effectuer une première distribution angulaire ou configuration spatiale de la lumière émise,
une seconde unité d'éclairage (114B) comportant :
une seconde diode émettrice de lumière (DEL) (116B, 146B, 156B) agencée sur le substrat (112, 142, 152), et
un second élément à lentille (124B) ayant une seconde prescription optique et agencé de façon à interagir avec de la lumière produite par la seconde DEL (116B, 146B, 156B) afin d'effectuer une seconde distribution angulaire ou configuration spatiale de la lumière émise, différente de la première distribution angulaire ou configuration spatiale de la lumière émise ;
**caractérisée en ce que** l'unité à lampe comporte en outre :
une unité de commande (130) ayant au moins deux modes de fonctionnement pouvant être choisis, comprenant :
un premier mode de fonctionnement pouvant être choisi dans lequel de l'énergie est appliquée à la première unité d'éclairage (114A), et
un second mode de fonctionnement pouvant être choisi dans lequel de l'énergie est appliquée à la seconde unité d'éclairage (114B), de manière que les première et seconde distributions angulaires ou configurations spatiales de la lumière émise puissent être obtenues sélectivement.

2. Lampe selon la revendication 1, dans laquelle l'unité de commande (130) a en outre :
un troisième mode de fonctionnement pouvant être choisi dans lequel de l'énergie est appliquée à la première unité d'éclairage (114A) et à la seconde unité d'éclairage (114B).

3. Lampe selon la revendication 1, dans laquelle :
l'émission de lumière depuis la première DEL (116A, 146A, 156A) a une première distribution spectrale ; et
l'émission de lumière depuis la seconde DEL (116B, 146B, 156B) a une seconde distribution spectrale qui est différente de la première distribution spectrale.

4. Lampe selon la revendication 1, dans laquelle :
au moins l'un du premier élément à lentille (124A) et du second élément à lentille (124B) comprend une région teintée grâce à quoi la distribution spectrale de l'émission de lumière de la, au moins une, unité d'éclairage (114A, 114B) qui comprend la région teintée est modifiée d'une manière préalablement choisie par la région teintée.

5. Lampe selon la revendication 1, comportant en outre :
un appareil (20, 40, 70) à variation de focale mobile mécaniquement qui comprend un système optique (18, 38, 88) qui interagit avec les première et seconde unités (114A, 114B) d'éclairage pour produire un point de faisceau lumineux de taille variable.
